# EUROPEAN PATENT APPLICATION

(11) **EP 3 223 271 A1**
(43) Date of publication of application: **27.09.2017**
(21) Application number: 17156606.0
(22) Date of filing: 17.02.2017
(51) Int. Cl.: G09G 3/36, G09G 3/3266, G09G 3/20, G11C 19/28

(54) **DISPLAY SCREEN ASSEMBLY, TERMINAL, AND METHOD FOR CONTROLLING DISPLAY SCREEN**

(30) Priority: 21.03.2016 CN 201610161640
(71) Applicant: Beijing Xiaomi Mobile Software Co., Ltd., Beijing 100085 (CN)
(72) Inventor: TANG, Lei, BEIJING, 100085 (CN); LIU, Anyu, BEIJING, 100085 (CN); WANG, Gang, BEIJING, 100085 (CN)
(74) Representative: Delumeau, François Guy

(57) **Abstract**

A display screen assembly includes a display screen (120, 220), a gate driving circuit (140, 240) and a driving IC (160, 260), wherein: the display screen is provided with n rows of successively arranged pixel rows (122, 222), and each row of the pixel row corresponds to a gate line (124, 224); the gate driving circuit is connected to n rows of the gate lines; the driving IC is connected to the gate driving circuit via at least two signal lines, a connection position between a first signal line (162, 262) and the gate driving circuit corresponds to the i-th row of gate line, and a connection position between a second signal line (164, 264) and the gate driving circuit corresponds to the j-th row of gate line; and wherein the signal lines are configured to transmit a frame initialing signal, and i and j are positive integers and i#j.

## Description

### TECHNICAL FIELD

The present invention generally relates to the field of display screen, and more particularly, to a display screen assembly, a terminal, and a method for controlling a display screen.

### BACKGROUND

A display screen is a most important input/output device of a mobile terminal, and is a most power consuming device of the mobile terminal.

In order to reduce the power consumption of the display screen, the display screen will be switched between a screen-on state and a screen-off state. When the display screen is switched from the screen-off state to the screen-on state, the entire display area of the display screen will be operated for displaying.

### SUMMARY

Accordingly, the present invention provides a display screen assembly, a terminal, and a method for controlling a display screen, in accordance with claims which follow.

In order to solve the problem that the power consumption is high when the entire display area is operated, the present invention provides a display screen assembly, a terminal, and a method for controlling a display screen. The technical solution is as below.

According to a first aspect, the present invention relates to a display screen assembly including a display screen, a gate driving circuit and a driving integrated circuit (IC), wherein:
the display screen is provided with n rows of successively arranged pixel rows, and each row of the pixel row corresponds to a gate line;
the gate driving circuit is connected to n rows of the gate lines;
the driving IC is connected to the gate driving circuit via at least two signal lines, a connection position between a first signal line and the gate driving circuit corresponds to the i-th row of gate line, and a connection position between a second signal line and the gate driving circuit corresponds to the j-th row of gate line; and
wherein the signal lines are configured to transmit a frame initialing signal, and i and j are positive integers and i≠j.

In a particular embodiment, the driving IC is configured to, in a first display mode, transmit a first frame initialing signal to the gate driving circuit via the first signal line; the gate driving circuit is configured to, upon receiving the first frame initialing signal, progressively scan from the i-th row of gate line to the n-th row of gate line;
the driving IC is configured to, in a second display mode, transmit a second frame initialing signal to the gate driving circuit via the second signal line; and the gate driving circuit is configured to, upon receiving the second frame initialing signal, progressively scan from the j-th row of gate line to the n-th row of gate line.

In a particular embodiment, the gate driving circuit includes an odd row gate driving circuit and an even row gate driving circuit;
the odd row gate driving circuit is connected with odd rows of gate lines in the n rows of gate lines; and
the even row gate driving circuit is connected with even rows of gate lines in the n rows of gate lines.

In a particular embodiment, the gate driving circuit is an array substrate gate driving GOA, the gate driving circuit includes a plurality of cascaded GOA units, and the GOA units and the gate lines are in one to one correspondence.

In a particular embodiment, i=1 and j>1.

In a particular embodiment, wherein the signal lines includes three or more signal lines, and the connection positions between each set of signal lines and the gate driving circuit correspond to different gate lines.

According to a second aspect, the present invention relates to a terminal including a processor and a display screen assembly according to the first aspect; and
the processor being connected with the driving IC in the display screen assembly.

According to a third aspect, the present invention relates to a method for controlling a display screen applicable in the display screen assembly according to the first aspect, the method including:
when the driving IC is in a first display mode, transmitting a first frame initialing signal to the gate driving circuit via the first signal line;
after the gate driving circuit receives the first frame initialing signal, progressively scanning from the i-th row of gate line to the n-th row of gate line;
when the driving IC is in a second display mode, transmitting a second frame initialing signal to the gate driving circuit via the second signal line; and
after the gate driving circuit receives the second frame initialing signal, progressively scanning from the j-th row of gate line to the n-th row of gate line.

In a particular embodiment, when the driving IC is in a first display mode, transmitting a first frame initialing signal to the gate driving circuit via the first signal line includes:
when the driving IC is in the first display mode, periodically transmitting the first frame initialing signal to the gate driving circuit via the first signal line according to a first period, wherein the first period is proportional to a first parameter, and the first parameter is a total number of the gate lines between the i-th row of gate line and the n-th row of gate line.

In a particular embodiment, when the driving IC is in a second display mode, transmitting a second frame initialing signal to the gate driving circuit via the second signal line includes:
when the driving IC is in the second display mode, periodically transmitting the second frame initialing signal to the gate driving circuit via the second signal line according to a second period, wherein the second period is proportional to a second parameter, and the second parameter is a total number of the gate lines between the j-th row of gate line and the n-th row of gate line.

In a particular embodiment, the driving IC receives a mode selecting instruction, and determines a current display mode according to the mode selecting instruction.

According to a fourth aspect, the present invention relates to a method for controlling a display screen applicable in the terminal according to the fourth aspect, the method including:
the processor sending a mode selecting instruction to the driving IC;
the driving IC receiving the mode selecting instruction and determining a current display mode according to the mode selecting instruction;
when the driving IC is in a first display mode, transmitting a first frame initialing signal to the gate driving circuit via the first signal line;
after the gate driving circuit receives the first frame initialing signal, progressively scanning from the i-th row of gate line to the n-th row of gate line;
when the driving IC is in a second display mode, transmitting a second frame initialing signal to the gate driving circuit via the second signal line; and
after the gate driving circuit receives the second frame initialing signal, progressively scanning from the j-th row of gate line to the n-th row of gate line.

In one particular embodiment, the steps of the methods for controlling a display screen are determined by computer program instructions.

Consequently, according to a fifth aspect, the present invention is also directed to a computer program for executing the steps of the methods for controlling a display screen as described above when this program is executed by a computer.

This program can use any programming language and take the form of source code, object code or a code intermediate between source code and object code, such as a partially compiled form, or any other desirable form.

The present invention is also directed to a computer-readable information medium containing instructions of a computer program as described above.

The information medium can be any entity or device capable of storing the program. For example, the support can include storage means such as a ROM, for example a CD ROM or a microelectronic circuit ROM, or magnetic storage means, for example a diskette (floppy disk) or a hard disk.

Alternatively, the information medium can be an integrated circuit in which the program is incorporated, the circuit being adapted to execute the methods in question or to be used in its execution.

In the embodiment of the present invention, by providing at least two signal lines for transmitting the frame initialing signal, a connection position between the first signal line and the gate driving circuit corresponds to the i-th gate line, and a connection position between the second signal line and the gate driving circuit corresponds to the j-th gate line, such that the driving IC is capable of progressively scanning from the i-th gate line as well as progressively scanning from the j-th gate line. Accordingly, the display area of the display screen may be controlled to operate in different display modes, and each display mode has an effect of having a display area with a different size.

It is to be understood that both the foregoing general description and the following detailed description are exemplary and explanatory only and are not restrictive of the present invention, as claimed.

### BRIEF DESCRIPTION OF THE DRAWINGS

The accompanying drawings, which are incorporated in and constitute a part of this specification, illustrate embodiments consistent with the present invention and, together with the description, serve to explain the principles of the present invention.
FIG. 1A is a schematic diagram illustrating a structure of a display screen assembly, according to an exemplary embodiment;
FIG. 1B is an operational diagram when the display screen assembly illustrated in the embodiment of FIG. 1A is in the first operating mode;
FIG. 1C is an operational diagram when the display screen assembly illustrated in the embodiment of FIG. 1A is in the second operating mode;
FIG. 2A is a schematic diagram illustrating a structure of a display screen assembly, according to another exemplary embodiment;
FIG. 2B is an operational diagram when the display screen assembly illustrated in the embodiment of FIG. 2A is in the first operating mode;
FIG. 2C is an operational diagram when the display screen assembly illustrated in the embodiment of FIG. 2A is in the second operating mode;
FIG. 2D is an operational diagram when the display screen assembly illustrated in the embodiment of FIG. 2A is in the second operating mode;
FIG. 3 is a schematic diagram illustrating a structure of a display screen assembly, according to another exemplary embodiment;
FIG. 4 is a schematic diagram illustrating a structure of a terminal, according to another exemplary embodiment;
FIG. 5 is a flow chart illustrating a method for controlling a display screen assembly, according to another exemplary embodiment; and
FIG. 6 is a flow chart illustrating a method for controlling a display screen assembly, according to another exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present invention. Instead, they are merely examples of apparatuses and methods consistent with aspects related to the present invention as recited in the appended claims.

While displaying information, it is unnecessary that the display screen is always displayed in full screen. For example, in case of displaying an unread message, only a part of the display area in the display screen is required. In order to reducing the power consumption of the display screen, embodiments of the present invention provides a display screen assembly having multiple display modes each corresponding to different sized display areas, thereby realizing the support of displaying both in full screen and in partial screen, or even in partial screen with various sizes.

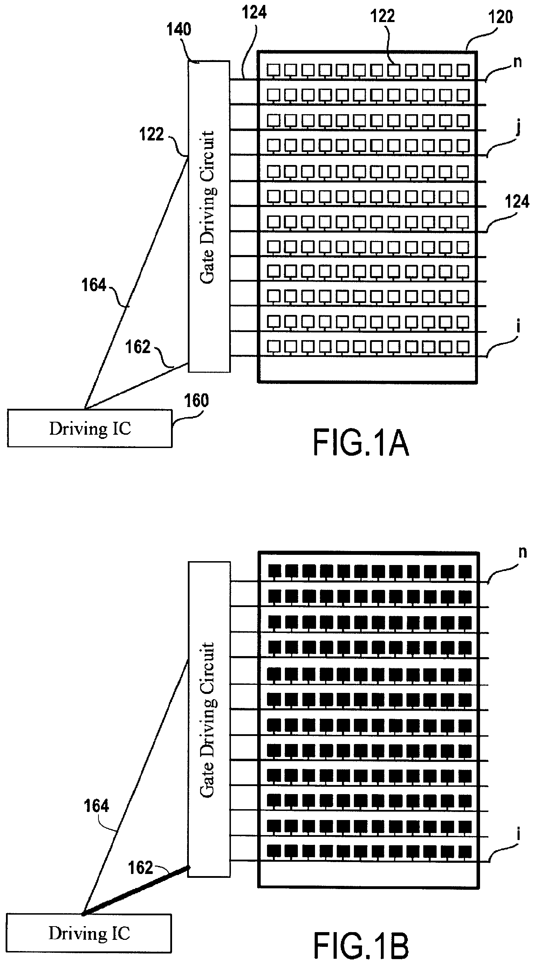

FIG. 1A is a schematic diagram illustrating a structure of a display screen assembly, according to an exemplary embodiment. The display screen assembly includes: a display screen 120, a gate driving circuit 140 and a driving integrated circuit (IC) 160.

The display screen 120 is provided with n rows of successively arranged pixel rows 122 each corresponding to a gate line 124. Optionally, each pixel row 122 includes m pixel units. For example, in a display screen having a resolution of 320*240, there are 240 rows of pixel rows 122 each including 320 pixel units (only a part of the pixels are illustrated in the drawings).

The gate driving circuit 140 is connected with n rows of gate lines 124. The gate driving circuit 140 is capable of progressively scanning the n rows of gate lines 124. Each pixel row 122 is operated (or functions) when the corresponding gate line 124 receives a scan signal. Optionally, the gate driving circuit 140 is a gate driver on array (GOA). The gate driving circuit includes a plurality of cascaded GOA units (not illustrated in the drawing), and the GOA units and the gate lines 124 are in one to one correspondence. For example, the i-th GOA unit is connected with the i-th row of gate line 124.

The driving IC 160 is connected with the gate driving circuit 140 via at least two signal lines. The signal lines are signal lines for transmitting a frame initialing signal. The frame initialing signal is also known as a start vertical (STV) signal for indicating the start of displaying each image frame.

A connection position between a first signal line 162 and the gate driving circuit 140 corresponds to the i-th row of gate line. In the present embodiment, the i-th row of gate line being the first row of gate line is taken for example.

A connection position 168 between a second signal line 164 and the gate driving circuit 140 corresponds to the j-th row of gate line. In the present embodiment, the j-th row of gate line being the 200th row of gate line is taken for example.

The driving IC 160 may have different display modes including a first display mode and a second display mode.

When the driving IC 160 is in the first display mode, the operating process includes the following steps.

The driving IC 160 is configured to, in a first display mode, transmit a first frame initialing signal to the gate driving circuit 140 via the first signal line 162.

The gate driving circuit 140 is configured to, upon receiving the first frame initialing signal, progressively scan from the i-th row of gate line to the n-th row of gate line. In this document, the wording "scan" means "activate".

Optionally, taken n=240 for example, the progressively scan from the i-th row of gate line to the n-th row of gate line refers to: transmitting a scan signal progressively to the i-th row of gate line, the (i+1)-th row of gate line, the (i+2)-th row of gate line, ..., the 240th row of gate line according to a first period, wherein each pixel row is operated when the corresponding gate line receives a scan signal. In this document, the wording "scan signal" means "activation signal".

When i=1, the gate driving circuit 140 progressively scans from the first row of gate line to the 240th row of gate line to complete the display of one image frame. At this time, the display screen 120 performs a full screen display, and the display area has a size corresponding to the entire display screen, as illustrated in FIG. 1B.

Optionally, when the display screen 120 displays each image frame, the driving IC 160 transmits the first frame initialing signal to the gate driving circuit 140 once.

When the driving IC 160 is in the second display mode, the operating process includes the following steps.

The driving IC 160 is configured to, in a second display mode, transmit a second frame initialing signal to the gate driving circuit 140 via the second signal line 164.

The gate driving circuit 140 is configured to, upon receiving the second frame initialing signal, progressively scan from the j-th row of gate line to the n-th row of gate line.

Optionally, taken n=240 for example, the progressively scan from the j-th row of gate line to the n-th row of gate line refers to: transmitting scan signal progressively to the j-th row of gate line, the (j+1)-th row of gate line, the (j+2)-th row of gate line, ..., the 240th row of gate line according to a second period, wherein each pixel row is operated when the corresponding gate line receives a scan signal.

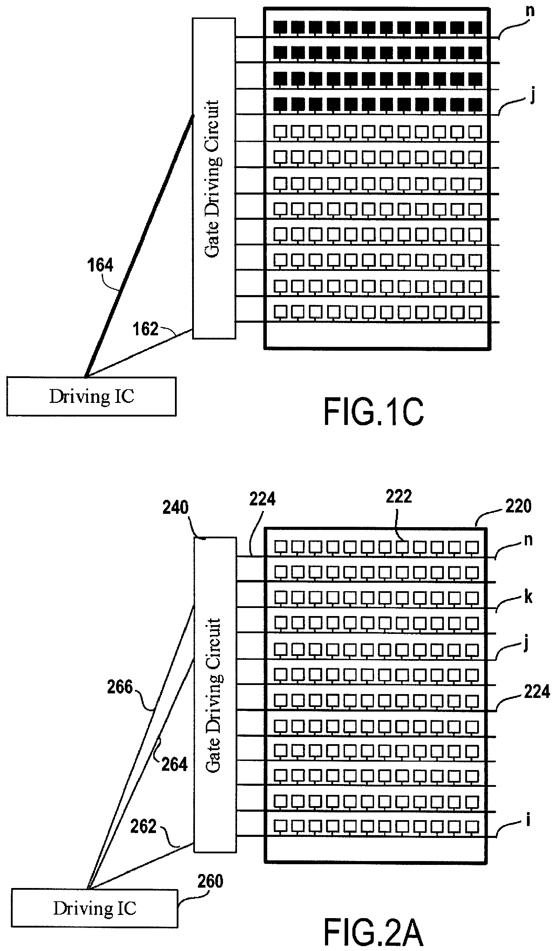

When j=200, the gate driving circuit 140 progressively scans from the 200th row of gate line to the 240th row of gate line to complete the display of one image frame. At this time, the display screen 120 performs a partial screen display, and the display area has a size corresponding to an area from the 200th row of pixel to the 240th row of pixel, as illustrated in FIG. 1C.

Optionally, when the display screen 120 displays each image frame, the driving IC 160 transmits the second frame initialing signal to the gate driving circuit 140 once.

To sum up, in the display screen assembly according to the present embodiment, by providing at least two signal lines for transmitting the frame initialing signal, a connection position between the first signal line and the gate driving circuit corresponds to the i-th gate line, and a connection position between the second signal line and the gate driving circuit corresponds to the j-th gate line, such that the driving IC is capable of progressively scanning from the i-th gate line as well as progressively scanning from the j-th gate line. Accordingly, the display area of the display screen may be controlled to operate in different display modes, and each display mode has an effect of having a display area with a different size.

In the embodiment of FIG. 1A, for example, the signal lines for transmitting the frame initialing signal include two signal lines. However, in various embodiments, the signal lines may include three or more signal lines. The connection positions between each set of signal lines and the gate driving circuit correspond to different gate lines.

FIG. 2A is a schematic diagram illustrating a structure of a display screen assembly, according to another exemplary embodiment. In the present embodiment, for example, the signal lines for transmitting frame initialing signal include three signal lines. The display screen assembly includes a display screen 220, a gate driving circuit 240 and a driving integrated circuit (IC) 260.

The display screen 220 is provided with n rows of successively arranged pixel rows 222 each corresponding to a gate line 224. Optionally, each pixel row 222 includes m pixel units. For example, in a display screen having a resolution of 1920*1080, there are 1080 rows of pixel rows 222 each including 1920 pixel units.

The gate driving circuit 240 is connected with n rows of gate lines 224. The gate driving circuit 240 is capable of progressively scanning the n rows of gate lines 224. Each pixel row 222 is operated when the corresponding gate line 224 receives a scan signal. Optionally, the gate driving circuit 240 is a gate driver on array (GOA). The gate driving circuit includes a plurality of cascaded GOA units (not illustrated in the drawing), and the GOA units and the gate lines 224 are in one to one correspondence. For example, the i-th GOA unit is connected with the i-th row of gate line 224.

The driving IC 260 is connected with the gate driving circuit 240 via three signal lines. The signal lines are signal lines for transmitting a frame initialing signal. The frame initialing signal is also known as a start vertical (STV) signal for indicating the start of displaying each image frame.

A connection position between a first signal line 262 and the gate driving circuit 240 corresponds to the i-th row of gate line. In the present embodiment, the i-th row of gate line being the first row of gate line is taken for example.

A connection position between a second signal line 264 and the gate driving circuit 240 corresponds to the j-th row of gate line. In the present embodiment, the j-th row of gate line being the 541st row of gate line is taken for example.

A connection position between a third signal line 266 and the gate driving circuit 240 corresponds to the k-th row of gate line. In the present embodiment, the k-th row of gate line being the 1001st row of gate line is taken for example.

The driving IC 260 may have different display modes including a first display mode, a second display mode and a third display mode.

When the driving IC 260 is in the first display mode, the operating process includes the following steps.

The driving IC 260 is configured to, in a first display mode, transmit a first frame initialing signal to the gate driving circuit 240 via the first signal line 262.

The gate driving circuit 240 is configured to, upon receiving the first frame initialing signal, progressively scan from the i-th row of gate line to the n-th row of gate line.

Optionally, taken n=1080 for example, the progressively scan from the i-th row of gate line to the n-th row of gate line refers to: transmitting scan signal progressively to the i-th row of gate line, the (i+1)-th row of gate line, the (i+2)-th row of gate line, ..., the 1080th row of gate line according to a first period, wherein each pixel row is operated when the corresponding gate line receives a scan signal.

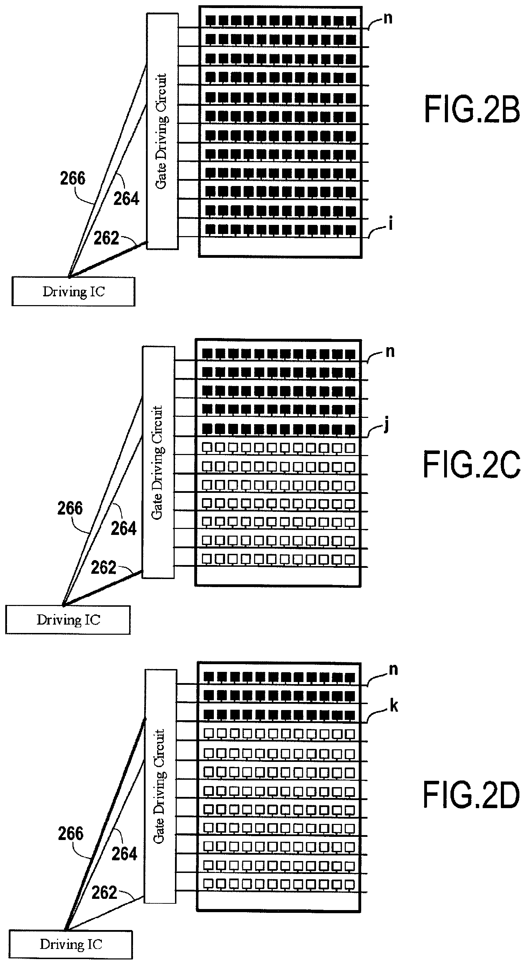

When i=1, the gate driving circuit 240 progressively scans from the first row of gate line to the 1080th row of gate line to complete the display of one image frame. At this time, the display screen 220 performs a full screen display, and the display area has a size corresponding to the entire display screen, as illustrated in FIG. 2B.

Optionally, when the display screen 220 displays each image frame, the driving IC 260 transmits the first frame initialing signal to the gate driving circuit 240 once.

When the driving IC 260 is in the second display mode, the operating process includes the following steps.

The driving IC 260 is configured to, in a second display mode, transmit a second frame initialing signal to the gate driving circuit 240 via the second signal line 264.

The gate driving circuit 240 is configured to, upon receiving the second frame initialing signal, progressively scan from the j-th row of gate line to the n-th row of gate line.

Optionally, taken n=1080 for example, the progressively scan from the j-th row of gate line to the n-th row of gate line refers to: transmitting scan signal progressively to the j-th row of gate line, the (j+1)-th row of gate line, the (j+2)-th row of gate line, ..., the 1080th row of gate line according to a second period, wherein each pixel row is operated when the corresponding gate line receives a scan signal.

When j=541, the gate driving circuit 240 progressively scans from the 541st row of gate line to the 1080th row of gate line to complete the display of one image frame. At this time, the display screen 220 performs a partial screen display, and the display area has a size corresponding to an area from the 541st row of pixel to the 1080th row of pixel, as illustrated in FIG. 2C.

Optionally, when the display screen 220 displays each image frame, the driving IC 260 transmits the second frame initialing signal to the gate driving circuit 240 once.

When the driving IC 260 is in the third display mode, the operating process includes the following steps.

The driving IC 260 is configured to, in a third display mode, transmit a third frame initialing signal to the gate driving circuit 240 via the second signal line 266.

The gate driving circuit 240 is configured to, upon receiving the third frame initialing signal, progressively scan from the k-th row of gate line to the n-th row of gate line.

Optionally, taken n=1080 for example, the progressively scan from the k-th row of gate line to the n-th row of gate line refers to: transmitting scan signal progressively to the k-th row of gate line, the (k+1)-th row of gate line, the (k+2)-th row of gate line, ..., the 1080th row of gate line according to a third period, wherein each pixel row is operated when the corresponding gate line receives a scan signal.

When k=1001, the gate driving circuit 240 progressively scans from the 1001st row of gate line to the 1080th row of gate line to complete the display of one image frame. At this time, the display screen 220 performs a partial screen display, and the display area has a size corresponding to an area from the 1001st row of pixel to the 1080th row of pixel, as illustrated in FIG. 2D.

Optionally, when the display screen 220 displays each image frame, the driving IC 260 transmits the third frame initialing signal to the gate driving circuit 240 once.

To sum up, in the display screen assembly according to the present embodiment, by providing at least two signal lines for transmitting the frame initialing signal, a connection position between the first signal line and the gate driving circuit corresponds to the i-th gate line, and a connection position between the second signal line and the gate driving circuit corresponds to the j-th gate line, such that the driving IC is capable of progressively scanning from the i-th gate line as well as progressively scanning from the j-th gate line. Accordingly, the display area of the display screen may be controlled to operate in different display modes, and each display mode has an effect of having a display area with a different size.

In the display screen assembly according to the present embodiment, by providing three or more signal lines, a connection position between the first signal line and the gate driving circuit corresponds to the first gate line, such that the display screen may operate in anyone of a full screen mode and two partial screen modes with different sizes.

In the embodiments of FIG. 1A and FIG. 2A, the gate driving circuit is an integrated circuit. In possible embodiments, the gate driving circuit may include two parts: an odd row gate driving circuit and an even row gate driving circuit. Please refer to the embodiments that follow.

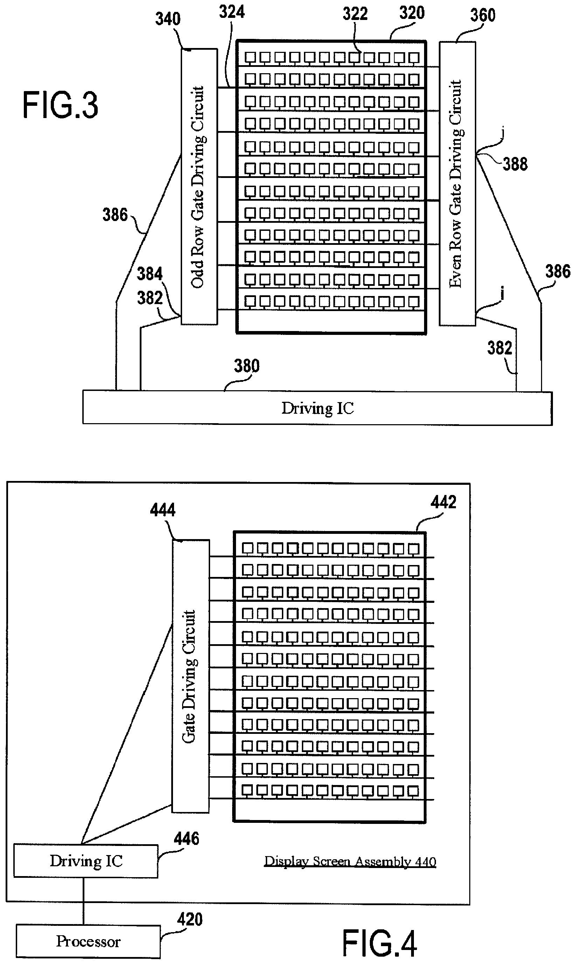

FIG. 3 is a schematic diagram illustrating a structure of a display screen assembly, according to another exemplary embodiment. The display screen assembly includes: a display screen 320, an odd row gate driving circuit 340, an even row gate driving circuit 360 and a driving integrated circuit (IC) 380.

The display screen 320 is provided with n rows of successively arranged pixel rows 322 each corresponding to a gate line 324. Optionally, each pixel row 322 includes m pixel units. For example, in a display screen having a resolution of 1920*1080, there are 1080 rows of pixel rows 322 each including 1920 pixel units.

The odd row gate driving circuit 340 is connected with odd rows of gate lines in the n rows of gate lines 324, i.e., the first row of gate line, the third row of gate line, the fifth row of gate line, the seventh row of gate line, ..., the (n-1)-th row of gate line (assuming that n is an even number).

The even row gate driving circuit 360 is connected with even rows of gate lines in the n rows of gate lines 324, i.e., the second row of gate line, the fourth row of gate line, the sixth row of gate line, the eighth row of gate line, ..., the n-th row of gate line (assuming that n is an even number).

The odd row gate driving circuit 340 is capable of progressively scanning odd rows of gate lines in the n rows of gate lines 324, and the even row gate driving circuit 360 is capable of progressively scanning even rows of gate lines in the n rows of gate lines 324. The odd row gate driving circuit 340 and the even row gate driving circuit 360 operate cooperatively to progressively scan from the first row of gate line to the n-th row of gate line. Each pixel row 322 is operated when the corresponding gate line 324 receives a scan signal. Optionally, the odd row gate driving circuit 340 and the even row gate driving circuit 360 are gate driver on arrays (GOA). The gate driving circuit includes a plurality of cascaded GOA units (not illustrated in the drawing), and the GOA units and the gate lines 324 are in one to one correspondence. For example, the i-th GOA unit is connected with the i-th row of gate line 324. The odd row gate driving circuit 340 includes cascaded odd GOA units, and the even row gate driving circuit 360 includes cascaded even GOA units.

The driving IC 380 is connected with the gate driving circuit via two sets of signal lines. Each set of signal lines includes two signal lines, wherein one signal line is connected with the odd row gate driving circuit 340, and the other signal line is connected with the even row gate driving circuit 360. The signal lines are signal lines for transmitting a frame initialing signal. The frame initialing signal is also known as a start vertical (STV) signal for indicating the start of displaying each image frame.

A connection position 384 between one signal line of a first set of signal lines 382 and one of the gate driving circuits corresponds to the i-th row of gate line.

A connection position 388 between one signal line of a second set of signal lines 386 and one of the gate driving circuits corresponds to the j-th row of gate line.

Optionally, the driving IC 380 includes two operating modes: a first display mode and a second display mode.

When the driving IC 380 is in the first display mode, the operating process includes the following steps.

The driving IC 380 is configured to, in a first display mode, transmit a first frame initialing signal to the odd row gate driving circuit 340 and the even row gate driving circuit 360 via the first set of signal lines 382.

The odd row gate driving circuit 340 and the even row gate driving circuit 360 are configured to, upon receiving the first frame initialing signal, progressively scan from the i-th row of gate line to the n-th row of gate line.

Optionally, when the display screen 320 displays each image frame, the driving IC 380 transmits the first frame initialing signal to the odd row gate driving circuit 340 and the even row gate driving circuit 360 once.

When the driving IC 380 is in the second display mode, the operating process includes the following steps.

The driving IC 380 is configured to, in a second display mode, transmit a second frame initialing signal to the odd row gate driving circuit 340 and the even row gate driving circuit 360 via the second set of signal lines 386.

The odd row gate driving circuit 340 and the even row gate driving circuit 360 are configured to, upon receiving the second frame initialing signal, progressively scan from the j-th row of gate line to the n-th row of gate line.

To sum up, in the display screen assembly according to the present embodiment, by providing at least two signal lines for transmitting the frame initialing signal, a connection position between the first signal line and the gate driving circuit corresponds to the i-th gate line, and a connection position between the second signal line and the gate driving circuit corresponds to the j-th gate line, such that the driving IC is capable of progressively scanning from the i-th gate line as well as progressively scanning from the j-th gate line. Accordingly, the display area of the display screen may be controlled to operate in different display modes, and each display mode has an effect of having a display area with a different size.

FIG. 4 is a schematic diagram illustrating a structure of a terminal, according to another exemplary embodiment. The terminal includes a processor 420 and a display screen assembly 440.

Optionally, the display screen assembly 440 is a display screen assembly according to any one of the embodiment illustrated in FIG. 1A, the embodiment illustrated in FIG. 2A and the embodiment illustrated in FIG. 3. The display screen assembly 440 includes a display screen 442, a gate driving circuit 444 and a driving IC 446.

The processor 420 is connected with the driving IC 446 in the display screen assembly 440.

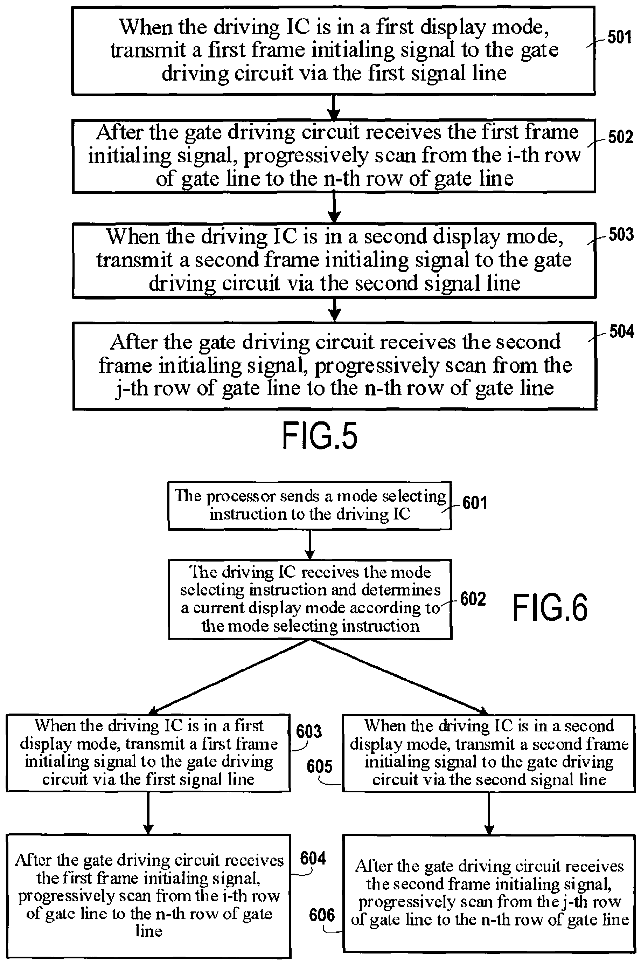

FIG. 5 is a flow chart illustrating a method for controlling a display screen assembly, according to another exemplary embodiment. For example, in the present embodiment, the method is applicable in any one of the embodiments illustrated in FIG. 1A, FIG. 2A and FIG. 3. The method includes the steps that follow.

In step 501, when the driving IC is in the first display mode, a first frame initialing signal is transmitted to the gate driving circuit via the first signal line.

Optionally, when the driving IC is in the first display mode, the first frame initialing signal is transmitted periodically to the gate driving circuit via the first signal line according to a first period.

In one embodiment, the first period is proportional to a first parameter, and the first parameter is a total number of the gate lines between the i-th row of gate line and the n-th row of gate line.

In step 502, after the gate driving circuit receives the first frame initialing signal, it progressively scans from the i-th row of gate line to the n-th row of gate line.

Each pixel row is operated when a corresponding gate line receives a scan signal.

In step 503, when the driving IC is in a second display mode, a second frame initialing signal is transmitted to the gate driving circuit via the second signal line.

Optionally, when the driving IC is in the second display mode, the second frame initialing signal is periodically transmitted to the gate driving circuit via the second signal line according to a second period.

In one embodiment, the second period is proportional to a second parameter, and the second parameter is a total number of the gate lines between the j-th row of gate line and the n-th row of gate line.

In step 504, after the gate driving circuit receives the second frame initialing signal, it progressively scans from the j-th row of gate line to the n-th row of gate line.

It should be noted that, the timings for performing the steps 503 and 504 and the steps 501 and 502 are not limited and are determined according to the current display mode of the driving IC. That is, steps 503 and 504 may be performed prior to the steps 501 and 502.

To sum up, in the method for controlling a display screen according to the present embodiment, when the driving IC is in a first display mode, transmitting a first frame initialing signal to the gate driving circuit via the first signal line; after the gate driving circuit receives the first frame initialing signal, progressively scanning from the i-th row of gate line to the n-th row of gate line; when the driving IC is in a second display mode, transmitting a second frame initialing signal to the gate driving circuit via the second signal line; and after the gate driving circuit receives the second frame initialing signal, progressively scanning from the j-th row of gate line to the n-th row of gate line. Accordingly, the display area of the display screen may be controlled to operate in different display modes, and each display mode has an effect of having a display area with a different size.

FIG. 6 is a flow chart illustrating a method for controlling a display screen assembly, according to another exemplary embodiment. For example, the method according to the present embodiment is applicable in the terminal according to the embodiment of FIG. 4. The method includes the steps that follow.

In step 601, the processor sends a mode selecting instruction to the driving IC.

The processor sends the mode selecting instruction to the driving IC according to the current operating mode. The mode selecting instruction is configured to instruct the driving IC to select one of the at least two display modes.

For example, when the current operating mode is playing video, the processor sends a mode selecting instruction for selecting the first display mode to the driving IC. Optionally, the first display mode is a full screen display mode.

For another example, when the current operating mode is displaying an unread message, the processor sends a mode selecting instruction for selecting the second display mode to the driving IC. Optionally, the second display mode is a partial screen display mode.

In step 602, the driving IC receives the mode selecting instruction and determines a current display mode according to the mode selecting instruction.

In step 603, when the driving IC is in a first display mode, a first frame initialing signal is transmitted to the gate driving circuit via the first signal line.

Optionally, when the driving IC is in the first display mode, the first frame initialing signal is transmitted periodically to the gate driving circuit via the first signal line according to a first period.

In one embodiment, the first period is proportional to a first parameter, and the first parameter is a total number of the gate lines between the i-th row of gate line and the n-th row of gate line.

In step 604, after the gate driving circuit receives the first frame initialing signal, it progressively scans from the i-th row of gate line to the n-th row of gate line.

Each pixel row is operated when a corresponding gate line receives a scan signal.

In step 605, when the driving IC is in a second display mode, a second frame initialing signal is transmitted to the gate driving circuit via the second signal line.

Optionally, when the driving IC is in the second display mode, the second frame initialing signal is periodically transmitted to the gate driving circuit via the second signal line according to a second period.

In one embodiment, the second period is proportional to a second parameter, and the second parameter is a total number of the gate lines between the j-th row of gate line and the n-th row of gate line.

In step 606, after the gate driving circuit receives the second frame initialing signal, it progressively scans from the j-th row of gate line to the n-th row of gate line.

It should be noted that, the timings for performing the steps 605 and 606 and the steps 603 and 604 are not limited and are determined according to the current display mode of the driving IC. That is, steps 605 and 606 may be performed prior to the steps 603 and 604.

To sum up, in the method for controlling a display screen according to the present embodiment, when the driving IC is in a first display mode, transmitting a first frame initialing signal to the gate driving circuit via the first signal line; after the gate driving circuit receives the first frame initialing signal, progressively scanning from the i-th row of gate line to the n-th row of gate line; when the driving IC is in a second display mode, transmitting a second frame initialing signal to the gate driving circuit via the second signal line; and after the gate driving circuit receives the second frame initialing signal, progressively scanning from the j-th row of gate line to the n-th row of gate line. Accordingly, the display area of the display screen may be controlled to operate in different display modes, and each display mode has an effect of having a display area with a different size.

Ordinal members, such as "first", "second", "third", or the like, as being used in the embodiments of the present invention, should be construed as being provided for distinction only, unless being otherwise clarified as being provided for indicating an order according to the context. When there are a plurality of signal lines, the "first" refers to one of the plurality of signal lines, and the "second" refers to another one of the plurality of signal lines.

## Claims

1. A display screen assembly, comprising a display screen (120, 220), a gate driving circuit (140, 240) and a driving integrated circuit "IC" (160, 260), **characterized in that**:
the display screen (120, 220) is provided with n rows of successively arranged pixel rows (122, 222), and each row of the pixel row (122, 222) corresponds to a gate line (124, 224);
the gate driving circuit (140, 240) is connected to n rows of the gate lines (124, 224);
the driving IC (160, 260) is connected to the gate driving circuit (140, 240) via at least two signal lines, a connection position between a first signal line (162, 262) and the gate driving circuit (140, 240) corresponds to the i-th row of gate line (124, 224), and a connection position (168) between a second signal line (164, 264) and the gate driving circuit (140, 240) corresponds to the j-th row of gate line (124, 224); and
wherein the signal lines are configured to transmit a frame initialing signal, and i and j are positive integers and i≠j.

2. The display screen assembly according to claim 1, wherein:
the driving IC (160, 260) is configured to, in a first display mode, transmit a first frame initialing signal to the gate driving circuit (140, 240) via the first signal line (162, 262);
the gate driving circuit (140, 240) is configured to, upon receiving the first frame initialing signal, progressively scan from the i-th row of gate line (124, 224) to the n-th row of gate line (124, 224);
the driving IC (160, 260) is configured to, in a second display mode, transmit a second frame initialing signal to the gate driving circuit (140, 240) via the second signal line (164, 264); and
the gate driving circuit (140, 240) is configured to, upon receiving the second frame initialing signal, progressively scan from the j-th row of gate line (124, 224) to the n-th row of gate line (124, 224).

3. The display screen assembly according to claim 1, wherein the gate driving circuit (140, 240) comprises an odd row gate driving circuit (340) and an even row gate driving circuit (360);
the odd row gate driving circuit (340) is connected with odd rows of gate lines (324) in the n rows of gate lines (324); and
the even row gate driving circuit (360) is connected with even rows of gate lines (324) in the n rows of gate lines (324).

4. The display screen assembly according to claim 1, wherein the gate driving circuit (140, 240) is an array substrate gate driving GOA, the gate driving circuit (140, 240) comprises a plurality of cascaded GOA units, and the GOA units and the gate lines (124, 224) are in one to one correspondence.

5. The display screen assembly according to any one of claims 1 to 4, wherein i=1 and j>1.

6. The display screen assembly according to any one of claims 1 to 4, wherein the signal lines comprises three or more signal lines, and the connection positions between each set of signal lines and the gate driving circuit (140, 240, 340, 360) correspond to different gate lines (124, 224, 324).

7. A terminal, **characterized in** comprising a processor (420) and a display screen assembly (440) according to any one of claims 1 to 6; and
the processor (420) being connected with the driving IC (446) in the display screen assembly (440).

8. A method for controlling a display screen applicable in the display screen assembly according to any one of claims 1 to 6, **characterized in** the method comprising:
when the driving IC is in a first display mode, transmitting (501) a first frame initialing signal to the gate driving circuit via the first signal line;
after the gate driving circuit receives the first frame initialing signal, progressively scanning (502) from the i-th row of gate line to the n-th row of gate line;
when the driving IC is in a second display mode, transmitting (503) a second frame initialing signal to the gate driving circuit via the second signal line; and
after the gate driving circuit receives the second frame initialing signal, progressively scanning (504) from the j-th row of gate line to the n-th row of gate line.

9. The method according to claim 8, wherein the when the driving IC is in a first display mode, transmitting (501) a first frame initialing signal to the gate driving circuit via the first signal line comprises:
when the driving IC is in the first display mode, periodically transmitting the first frame initialing signal to the gate driving circuit via the first signal line according to a first period, wherein the first period is proportional to a first parameter, and the first parameter is a total number of the gate lines between the i-th row of gate line and the n-th row of gate line.

10. The method according to claim 8, wherein the when the driving IC is in a second display mode, transmitting (503) a second frame initialing signal to the gate driving circuit via the second signal line comprises:
when the driving IC is in the second display mode, periodically transmitting the second frame initialing signal to the gate driving circuit via the second signal line according to a second period, wherein the second period is proportional to a second parameter, and the second parameter is a total number of the gate lines between the j-th row of gate line and the n-th row of gate line.

11. The method according to any one of claims 8 to 10, wherein,
the driving IC receives a mode selecting instruction, and determines a current display mode according to the mode selecting instruction.

12. A method for controlling a display screen applicable in the terminal according to claim 7, **characterized in** the method comprising:
the processor sending (601) a mode selecting instruction to the driving IC;
the driving IC receiving (602) the mode selecting instruction and determining a current display mode according to the mode selecting instruction;
when the driving IC is in a first display mode, transmitting (603) a first frame initialing signal to the gate driving circuit via the first signal line;
after the gate driving circuit receives the first frame initialing signal, progressively scanning (604) from the i-th row of gate line to the n-th row of gate line;
when the driving IC is in a second display mode, transmitting (605) a second frame initialing signal to the gate driving circuit via the second signal line; and
after the gate driving circuit receives the second frame initialing signal, progressively scanning (606) from the j-th row of gate line to the n-th row of gate line.

13. A computer program, which when executing on a processor, performs a method according to any one of claims 8 to 12.

14. A recording medium readable by a processor and having recorded thereon a computer program including instructions for executing the steps of a method according to any one of claims 8 to 12.
